# EUROPEAN PATENT SPECIFICATION

(11) **EP 1 459 900 B1**
(45) Date of publication and mention of the grant of the patent: **29.04.2009**
(21) Application number: 04251611.2
(22) Date of filing: 19.03.2004
(51) Int. Cl.: B41J 2/14, B41J 2/16, H01L 41/24

(54) **Method for forming a piezoelectric actuator for an ink-jet printhead**
Verfahren zur Herstellung von einem piezoelektrischen Aktuator eines Tintenstrahldruckkopfes
Procédé de formation d'un actionneur piézo-électrique d'une tête d'impression à jet d'encre

(30) Priority: 20.03.2003 KR 2003017388
(43) Date of publication of application: 22.09.2004
(73) Proprietor: SAMSUNG ELECTRONICS CO., LTD., Suwon-si, Gyeonggi-do (KR)
(72) Inventor: Lim, Seung-mo, Yongin-si Gyeonggi-do (KR); Lee, Jae-chang, Hwaseong-si Gyeonggi-do (KR); Chung, Jae-woo, Suwon-si Gyeonggi-do (KR)
(74) Representative: Anderson, James Edward George

(56) References cited:
- EP-A- 0 782 923
- EP-A- 1 067 609
- US-A- 5 956 829
- US-B1- 6 198 203
- US-B1- 6 265 139

## Description

The present invention relates to a piezoelectric ink-jet printhead, and more particularly, to a piezoelectric actuator for providing a driving force of ejecting ink in a piezoelectric ink-jet, and a method for forming the piezoelectric actuator.

Typically, ink-jet printheads are devices for printing a predetermined color image by ejecting a small volume of droplet of printing ink at a desired position on a recording sheet. In such ink-jet printheads, ink ejection mechanisms are largely categorized into several types. Conventionally, there have been used a thermally driven type in which a heat source is employed to generate bubbles in ink to cause ink droplets to be ejected by an expansion force of the generated bubbles, and a piezoelectrically driven type in which ink is ejected by a pressure applied to ink due to deformation of a piezoelectric element.

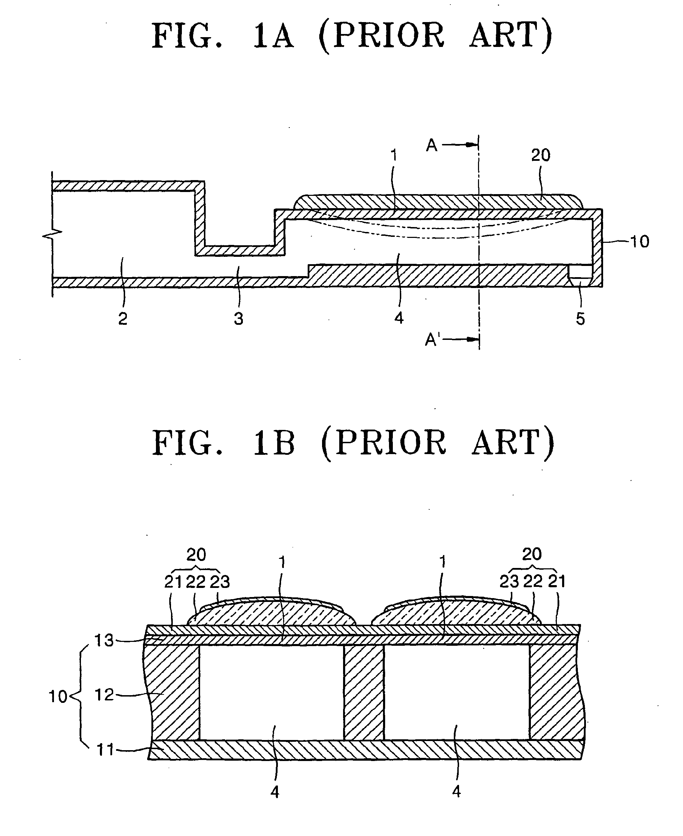

FIG. 1A shows a general piezoelectric ink-jet printhead. Referring to FIG.1A, a reservoir 2, a restrictor 3, a pressure chamber 4 and a nozzle 5 are formed in a passage forming plate 10, forming an ink passage. A piezoelectric actuator 20 is provided on the passage forming plate 10. The reservoir 2 stores ink introduced from an ink container (not shown). The restrictor 3 is a passage through which the ink is induced from the reservoir 2 to the pressure chamber 4. The pressure chamber 4 is filled with ink to be expelled and varies in its volume as the piezoelectric actuator 20 is driven, thereby causing a change in pressure for expelling or inducing the ink. To this end, a portion forming an upper wall of the pressure chamber 4 in the passage forming plate 10 serves as a vibration plate 1 which deforms by the piezoelectric actuator 20.

The above-described conventional piezoelectric ink-jet printhead operates as follows. When the vibration plate 1 deforms due to driving of the piezoelectric actuator 20, the volume of the pressure chamber 4 decreases, causing a change in the pressure within the pressure chamber 4, so that the ink in the pressure chamber 4 is expelled through the nozzle 5. Then, when the vibration plate 1 is restored to have its original shape as the piezoelectric actuator 20 is driven, the volume of the pressure chamber 4 increases, causing a change in the volume, so that the ink stored in the reservoir 2 is induced into pressure chamber 4 through the restrictor 3.

FIG. 1B is a detailed diagram of the piezoelectric actuator. Referring to FIG. 1B, the passage forming plate 10 is formed by fabricating a plurality of thin plates 11, 12, 13 formed of ceramics, metals, synthetic resin or silicon substrates or plastics, forming a part of the ink passage, and then stacking the plurality of thin plates using an adhesive. As such, the plate 13 stacked above the pressure chamber 4 serves as a vibration plate 1. The piezoelectric actuator 20 includes a lower electrode 21, a piezoelectric film 22 and an upper electrode 23, which are sequentially stacked on the vibration plate 1. The lower electrode 21 is formed by sputtering a predetermined metal material on the vibration plate 1. The piezoelectric film 22 is formed by applying a paste-state ceramic material on the lower electrode 21 to a predetermined thickness by screen printing and sintering the same. The upper electrode 23 is formed by applying a conductive material onto a surface of the piezoelectric film 22 by screen printing or depositing by means of a sputter, evaporator or E-beam irradiator.

However, since the piezoelectric film 22 formed by the conventional screen printing method spreads laterally in view of paste-state material characteristics, it is more difficult to obtain a correctly sized, rectangular-shaped film. That is, the formed film22 is thick at its middle portion and thin at its edge portions. To cope with such a problem, conventionally, the upper electrode 23 is formed only at the thick, middle portion, excluding the thin, peripheral portions of the piezoelectric film 22. Even slight misplacement of the upper electrode 23 on the piezoelectric film 22 may result in short between the upper electrode 23 and the lower electrode 21. After the piezoelectric film 22 is sintered, an electric field is applied to the piezoelectric film 22, producing piezoelectric characteristics, which is called a polling process. In the polling process, a high electric field of about10 kV/cm is applied between the upper electrode 23 and the lower electrode 21. If the upper electrode 23 is formed at the thin, peripheral portions of the piezoelectric film 22, a gap between the upper electrode 23 and the lower electrode 21 is reduced so that breakdown occurs, causing cracking to the piezoelectric film 22 or adversely affecting piezoelectric characteristics of the piezoelectric film 22.

To address these problems, the upper electrode 23 is formed only at the thick, middle portion of the piezoelectric film 22, rather than at the thin, peripheral portions. Thus, a width of the upper electrode 23 becomes much smaller than that of the piezoelectric film 22. As a result, the piezoelectric film 22 cannot sufficiently exhibit piezoelectric effects.

For a better print quality, that is, high resolution, fast printing, increasing the nozzle density is necessary. To this end, the size of the pressure chamber 4 and the distance between neighboring pressure chambers 4 should be reduced, and the width of the piezoelectric film 22 is reduced accordingly. If the width of the piezoelectric film 22 is reduced, however, it is more difficult to form the upper electrode 23 on the piezoelectric film 22 by the conventional piezoelectric actuator formation method, which impedes forming the piezoelectric actuator 20. According to the conventional method, the margin of a line width is generally known as about 50 µm.

U.S. Patent No. 5,956,829 discloses a piezoelectric actuator in which a drive electrode is formed to directly contact a vibration plate, and a width of the drive electrode or piezoelectric film is smaller than that of the vibration plate. U.S. Patent No. 5,929,881 discloses a piezoelectric actuator in which a width of a lower electrode is made smaller than that of a pressure chamber for efficiently vibrating the vibration plate. However, the known piezoelectric actuators have different shructure and formation method from the piezoelectric actuator of the present invention.

EP 1067609 A1 discloses a piezoelectric actuator having a piezoelectric thin film provided between upper and lower electrodes. The vertical cross sectional shape of the piezoelectric thin film is a quadrilateral having an upper surface longer than a lower surface. The actuator is manufactured by a method according to the preamble of claim 1.

According to the invention, there is provided a method for forming a piezoelectric actuator for an ink-jet printhead, the piezoelectric actuator being formed on a vibration plate which forms an upper wall of a pressure chamber and being for deforming the vibration plate for providing a driving force to the pressure chamber for ejecting ink, the method comprising: forming a lower electrode on the vibration plate; forming a piezoelectric film on the lower electrode in a position that corresponds to the pressure chamber; and forming an upper electrode on the piezoelectric film; wherein the method is characterized in that forming the piezoelectric film and the upper electrode comprises coating a photoresist on the entire surface of the lower electrode to a predetermined thickness, patterning the photoresist to form an opening in a position corresponding to the pressure chamber, coating a piezoelectric material on the lower electrode exposed by the opening to form the piezoelectric film, forming the upper electrode on the piezoelectric film, removing the photoresist, sintering the piezoelectric film, and applying an electric field to the piezoelectric film to provide piezoelectric properties, wherein the piezoelectric material is coated more widely than a width of the opening, so that a space between the peripheral portion of the piezoelectric film and the lower electrode is formed when the photoresist is removed.

In the above-described method for forming a piezoelectric actuator according to the present invention, a width of the opening may be about 70 to 90% that of the pressure chamber. The coating of the piezoelectric material may be performed by screen printing. The pressure chamber and the vibration plate may be formed in a silicon substrate. A silicon oxide layer may be formed between the silicon substrate and the lower electrode. The lower electrode may be formed by sequentially depositing a Ti layer and a Pt layer on the vibration plate by sputtering. The upper electrode may be formed by printing an electrode material on the piezoelectric film. Alternatively, the upper electrode may be formed by depositing an electrode material on the piezoelectric film by means of one selected from the group consisting of a sputter, an evaporator, and an E-beam irradiator.

As described above, according to the present invention, a wider upper electrode can be formed, thereby exhibiting sufficient piezoelectric effects and preventing breakdown of the piezoelectric film during polling or driving.

The present invention thus provides a method for manufacturing a piezoelectric actuator for an ink-jet printhead, which can form a wider upper electrode to offer sufficient piezoelectric effects and can prevent breakdown of a piezoelectric film during a polling or driving process.

The above aspects and advantages of the present invention will become more apparent by describing in detail exemplary embodiments thereof with reference to the attached drawings in which:
FIG. 1 is a schematic diagram of a conventional ink-jet printhead, and FIG. 1B is a cross-sectional view of a conventional piezoelectric actuator taken along line A-A' of FIG. 1A;
FIG. 2 is a cross-sectional view illustrating a structure of a piezoelectric actuator for an ink-jet printhead according to a first embodiment of the present invention;
FIG. 3 is a cross-sectional view illustrating a structure of a piezoelectric actuator for an ink-jet printhead not according to the present invention;
FIGS. 4A through 4D show analysis results of displacement of a vibration plate depending on shapes of a piezoelectric film and an upper electrode;
FIGS. 5A through 5H show sequential steps of a method of forming the piezoelectric actuator shown in FIG. 2;
FIGS. 6A through 6E show sequential steps of a method of forming the piezoelectric actuator shown in FIG. 3; and
FIGS. 7A and 7B are scanning electron microscope pictures of the piezoelectric actuator formed by the method shown in FIGS. 6A through 6E.

The present invention will now be described more fully with reference to the accompanying drawings, in which preferred embodiments of the invention are shown. In the drawings, like reference numerals appearing in different drawings represent like elements and the shape and thickness of an element may be exaggerated for clarity. Further, it will be understood that when a layer is referred to as being "on" another layer or substrate, it may be directly on the other layer or substrate, or intervening layers may also be present.

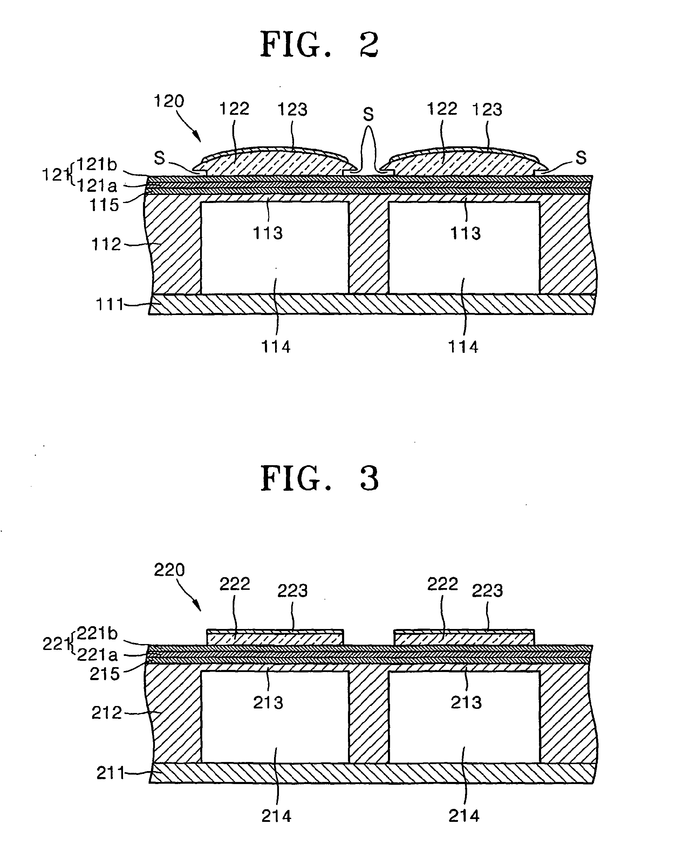

FIG. 2 is a cross-sectional view illustrating a structure of a piezoelectric actuator for an ink-jet printhead according to a first embodiment of the present invention.

Referring to FIG. 2, the piezoelectric actuator 120 of an ink-jet printhead according to a first embodiment of the present invention is formed on a vibration plate 113 forming an a upper wall of a pressure chamber 114 and deforms the vibration plate 113, thereby providing a driving force of ejecting ink to the pressure chamber 114. The piezoelectric actuator 120 includes a lower electrode 121 serving as a common electrode, a piezoelectric film 122 which is deformable according to application of a voltage, and an upper electrode 123 serving as a drive electrode. The lower electrode 121, the piezoelectric film 122 and the upper electrode 123 are sequentially stacked on the vibration plate 113.

As described above, in the piezoelectric ink-jet printhead are provided a pressure chamber 114 filled with ink to be ejected, and an ink passage (not shown) for supplying the pressure chamber 114 with ink and ejecting ink from the pressure chamber 114. The ink passage is formed on a plurality of plates including a base plate 111 and a chamber forming plate 112.

The lower electrode 121 is formed on the vibration plate 113. The lower electrode 121 may be formed of a single metal layer having a conductive property, and is preferably formed of two metal layers of a Ti layer 121 a and a Pt layer 121 b, as shown FIG. 2. The Ti/Pt layers 121 a, 121 b serve as not only a common electrode but also a diffusion barrier layer for preventing inter-diffusion between the piezoelectric film 122 and the vibration plate 113.

In the case where the vibration plate 113 is made of silicon, a silicon oxide layer 115 as an insulating layer may be formed between the vibration plate 113 and the lower electrode 121. The silicon oxide layer 115 not only serves as an insulating layer but also functions to suppress inter-diffusion and thermal stress between the vibration plate 113 and the lower electrode 121.

The piezoelectric film 122 is formed on the lower electrode 121 and disposed at a position corresponding to the pressure chamber 114. A space S having a predetermined width and height is formed between either side of the piezoelectric film 122 and the lower electrode 121. Here, a distance between the spaces S formed at the sides of the piezoelectric film 122, that is, a width of a portion of the piezoelectric film 122 contacting the lower electrode 121 is preferably about 70 to about 90% that of the pressure chamber 114.

The upper electrode 123 is formed on the piezoelectric film 122 and serves as a drive electrode for applying a voltage to the piezoelectric film 122.

In the aforementioned piezoelectric actuator 120 of the ink-jet printhead according to the first embodiment of the present invention, since the space S having a predetermined width and height is formed between either side of the piezoelectric film 122 and the lower electrode 121, even if the upper electrode 123 is formed to be wider than the conventional one, short between the upper electrode 123 and the lower electrode 121 does not occur. Also, no breakdown occurs to the piezoelectric film 122 during polling or driving of the piezoelectric actuator 120. Thus, the piezoelectric actuator 120 according to the present invention advantageously exhibits sufficient piezoelectric effects by the wider upper electrode 123.

FIG. 3 is a cross-sectional view illustrating a structure of a piezoelectric actuator for an ink-jet printhead not according to the present invention. The piezoelectric actuator is the same as that of the first embodiment, except for the shape of the piezoelectric film. Thus, the same parts as those in the first embodiment will not be described or an explanation thereof will briefly be given.

Referring to FIG. 3, the piezoelectric actuator 220 of an ink-jet printhead includes a lower electrode 221 serving as a common electrode, a piezoelectric film 222 which is deformable according to application of a voltage, and an upper electrode 223 serving as a drive electrode. The lower electrode 221, the piezoelectric film 222 and the upper electrode 223 are sequentially stacked on the vibration plate 213.

The pressure chamber 214 and an ink passage (not shown) are formed on a plurality of plates having a base plate 211 and a chamber forming plate 212, and the vibration plate 213 forms an upper wall of the pressure chamber 214.

The lower electrode 221 is formed on the vibration plate 213 and may be formed of two metal layers of a Ti layer 221 a and a Pt layer 221 b, as shown in FIG. 3. The Ti/Pt layers 221 a, 221 b serve in the same way as in the first embodiment. In the case where the vibration plate 213 is made of silicon, like in the first embodiment, a silicon oxide layer 215 as an insulating layer may be formed between the vibration plate 213 and the lower electrode 221.

The piezoelectric film 222 is formed on the lower electrode 221 and disposed at a position corresponding to the pressure chamber 214. Also, the lateral surface of the piezoelectric film 222 is substantially at right angle with respect to the top surface of the lower electrode 221. The piezoelectric film 222 preferably has a rectangular section having a constant height. Also, a width of the piezoelectric film 222 is preferably about 70 to about 90% that of the pressure chamber 214.

The upper electrode 223 is formed on the piezoelectric film 222 and preferably has the same width as the piezoelectric film 222.

In the aforementioned piezoelectric actuator 220 of the ink-jet printhead, since the lateral surface of the piezoelectric film 222 is substantially at right angle with respect to the top surface of the lower electrode 221, there is no thin peripheral portion in the piezoelectric film 222. Also, the piezoelectric film 222 has a rectangular section having a constant height. Thus, the width of the upper electrode 223 can be made the same as that of the piezoelectric film 222, thereby allowing the piezoelectric actuator 220 to exhibit the maximum piezoelectric effects without causing short between the upper electrode 223 and the lower electrode 221 or breakdown to the piezoelectric film 222. Also, since the piezoelectric film 222 is formed thinly to have a predetermined thickness, the piezoelectric actuator 220 of a smaller size can be accurately formed and a distance between neighboring piezoelectric films 220 can be reduced. Thus, the piezoelectric actuator 222 can be arranged in a high density, thereby easily implementing an ink-jet printhead having high resolution.

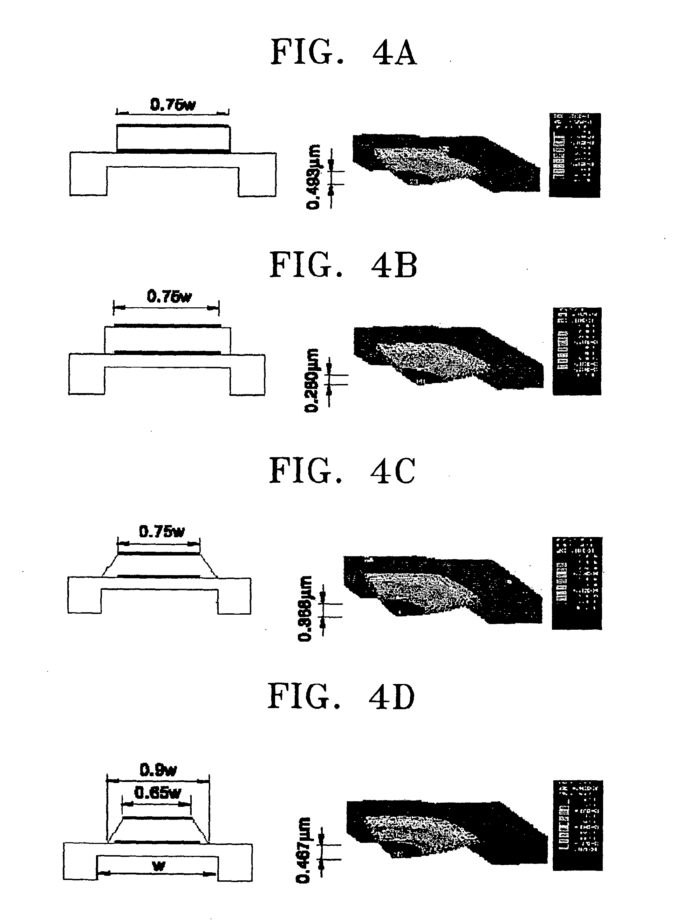

FIGS. 4A through 4D show analysis results of displacement of a vibration plate depending on shapes of a piezoelectric film and an upper electrode. In each drawing, the structure of each piezoelectric actuator is shown in the left and the analysis result of the structure is shown in the right.

In detail, FIG. 4A shows the analysis result of displacement of a vibration plate in the piezoelectric actuator shown in Figure 3. Here, the piezoelectric film has a rectangular section, and the width of the piezoelectric film and electrodes is about 75% a width W of the pressure chamber. The analysis result showed that the displacement of the vibration plate deformable by the piezoelectric actuator was about 0.493 µm.

In FIG. 4B, the width of the piezoelectric film is the same as a width W of the pressure chamber and widths of the electrodes are about 75% the width W of the pressure chamber. The analysis result showed that the displacement of the vibration plate deformable by the piezoelectric actuator was about 0.280 µm, which is about 57% that in the case shown in FIG. 4A.

Referring to FIG. 4C, the piezoelectric film has a width the same as the width W of the pressure chamber while the peripheral portions thereof are thin. The width of the electrodes is about 75% the width W of the pressure chamber. The analysis result showed that the displacement of the vibration plate deformable by the piezoelectric actuator was about 0.368 µm, which is about 75% of that in the case shown in FIG. 4A.

In FIG. 4D, the width of the piezoelectric film is about 90% a width Wof the pressure chamber while the peripheral portions thereof are thin. A width of the upper electrode is about 65% the width W of the pressure chamber. The analysis result showed that the displacement of the vibration plate deformable by the piezoelectric actuator was about 0.467 µm, which is about 94% of that in the case shown in FIG. 4A.

As described above, when the piezoelectric film has a rectangular section and the width thereof is smaller than that of the pressure chamber, the displacement of the vibration plate is largest. Therefore, as shown in FIG.4A, the piezoelectric actuator shown in Figure 3 can efficiently vibrate the vibration plate. For the reasons stated above, in the piezoelectric actuator according to the first embodiment of the present invention, it is preferable that a width of a portion of the piezoelectric film, the portion contacting the lower electrode is narrower than that of the pressure chamber.

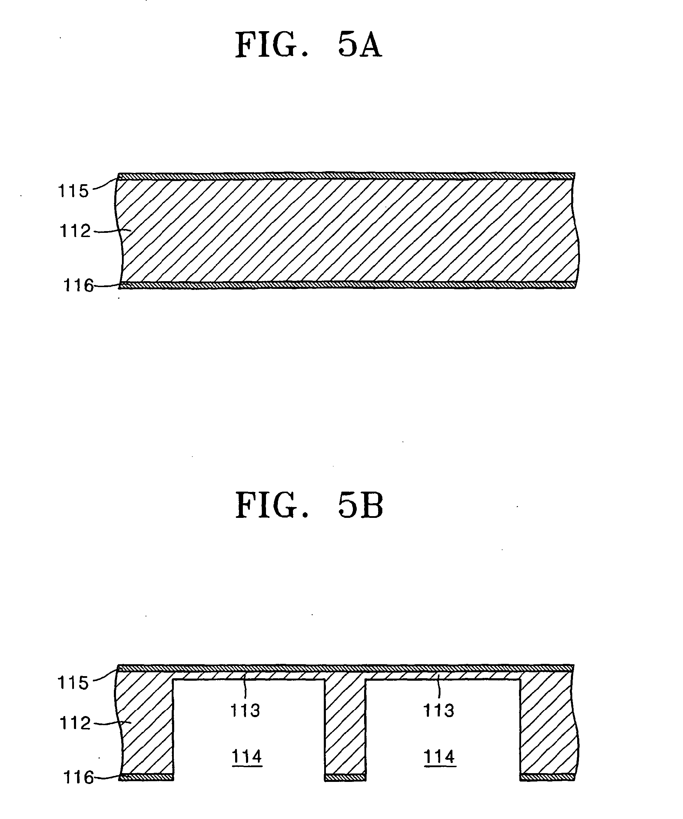

FIGS. 5A through 5H show sequential steps of a method according to the invention of forming the piezoelectric actuator shown in FIG. 2.

Referring first to FIGS. 5A and 5B, the vibration plate 113, forming an upper wall of the pressure chamber 114, can be formed by etching a silicon substrate 112 to a predetermined depth from the bottom surface of the silicon suloshare112, simultaneously with formation of the pressure chamber 114. In detail, as shown in FIG.5A, the silicon substrate 112 is wet or dry oxidized in an oxidation furnace, thereby forming silicon oxide layers 115 and 116.

Subsequently, as shown in FIG. 5B, the silicon oxide layer 116, which is formed on the bottom of the silicon substrate 112, is patterned using a photoresist pattern to expose a portion of the silicon substrate 112, which is a potential portion of the pressure chamber 114, and the exposed substrate 112 is dry or wet etched to a predetermined depth, thereby forming the pressure chamber 114. Here, a portion of the substrate 112 remaining after being etched forms the vibration plate 113.

The pressure chamber 114 and the vibration plate 113 can be formed by another known technology. For example, the pressure chamber 114 and the vibration plate 113 can be formed on different substrates. In this case, a separate substrate is adhered to a substrate through which the pressure chamber 114 is formed, forming the vibration plate 113.

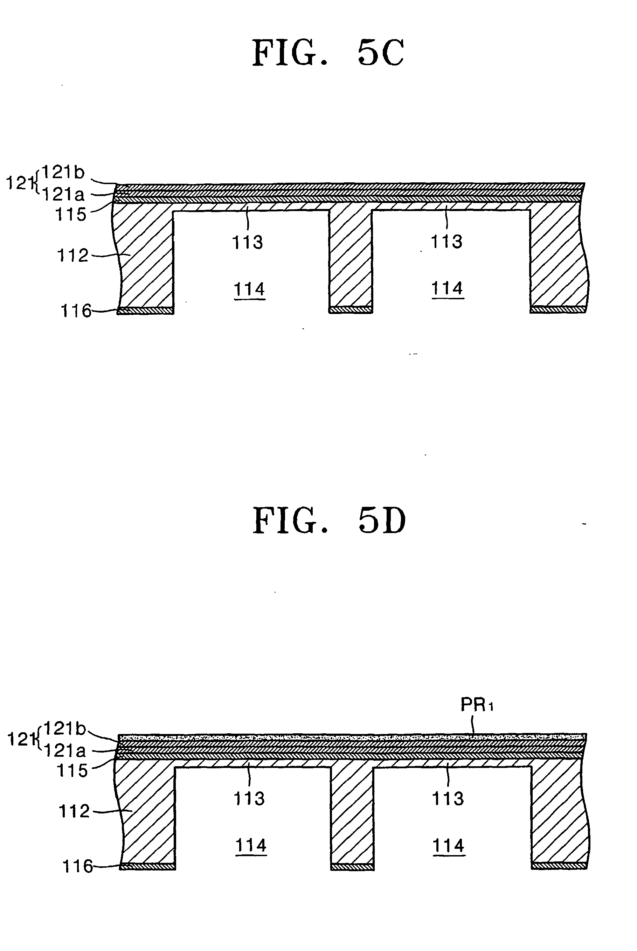

As shown in FIG. 5C, the lower electrode 121 is formed on the entire surface of the silicon oxide layer 115 formed on the silicon substrate 112. As described above, the lower electrode 121 may be formed of two metal layers, that is, a titanium (Ti) layer 121 a and a platinum (Pt) layer 121 b. The Ti layer 121 a can be formed by depositing Ti on the entire surface of the oxide layer 115 to a thickness of about 40 nm (400Å) by sputtering and the Pt layer 121 b can be formed by depositing Pt on the entire surface of the Ti layer 121a to a thickness of about 500 nm (5,000Å) by sputtering.

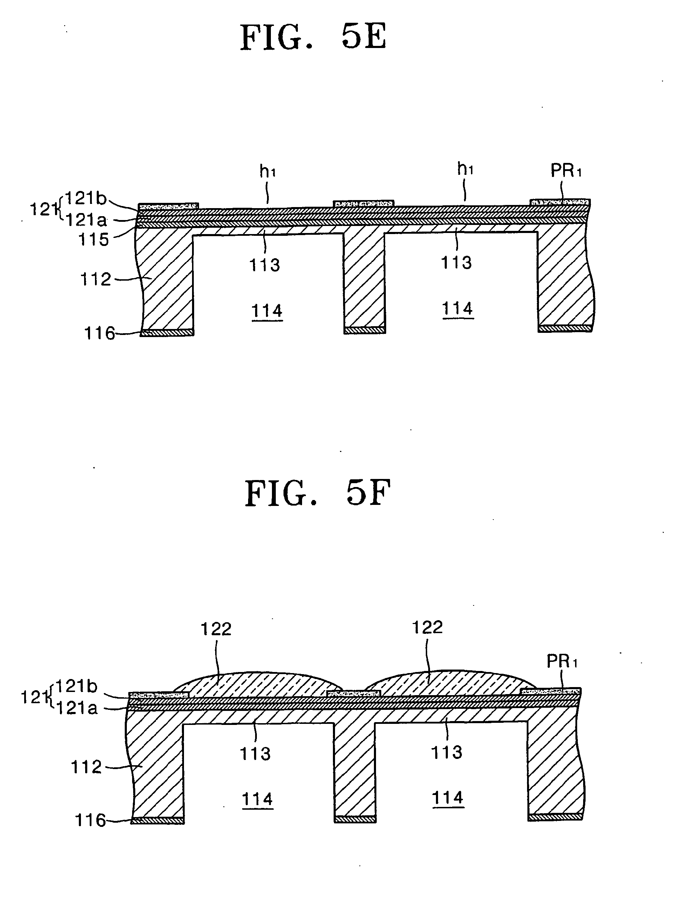

Next, as shown in FIG. 5D, a photoresist PR₁ is coated on the entire surface of the lower electrode 121 to a predetermined thickness, e.g., about 2 to 8 µm. Subsequently, the coated photoresist PR₁ is exposed and developed for patterning, thereby forming an opening h₁ having a width of about 70 to 90% that of the pressure chamber 114 at a position corresponding to the pressure chamber 114, as shown in FIG. 5E. A portion of the lower electrode 121 is exposed through the opening h₁.

Then, a piezoelectric material in a paste state is coated on the exposed lower electrode 121 slightly more widely than the width of the opening h₁ by screen-printing, thereby forming a piezoelectric film 122, as shown in FIG. 5F. Various materials, preferably lead zirconate titanate (PZT) ceramics, are used for the piezoelectric material.

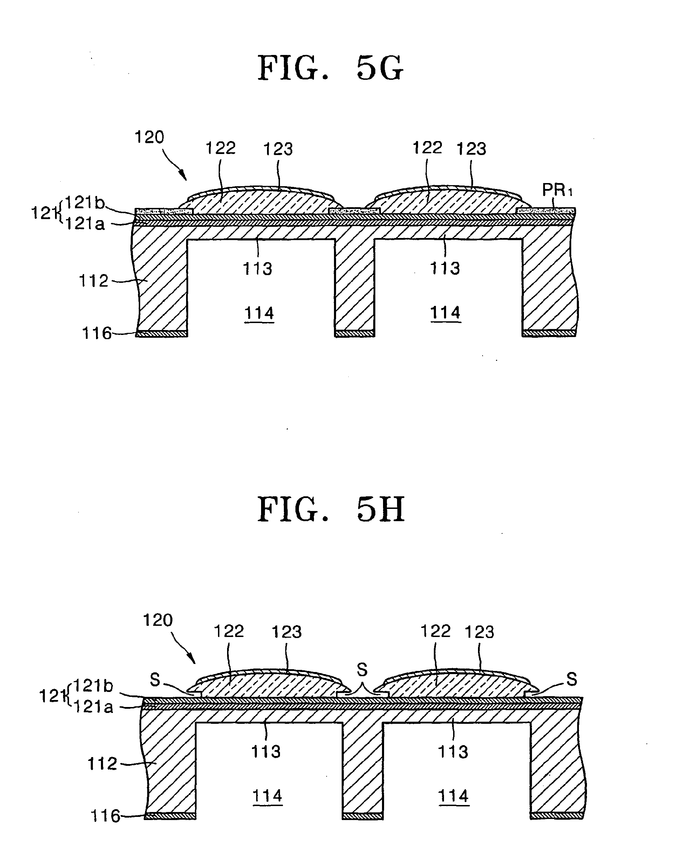

Subsequently, as shown in FIG. 5G, an upper electrode 123 is formed on the piezoelectric film 122. In detail, an electrode material, for example, Ag-Pd paste, is printed on the piezoelectric film 122 to form the upper electrode 123. Alternatively, the upper electrode 123 may be formed by depositing a predetermined electrode material onto a surface of the piezoelectric film 122 to a predetermined thickness using a shadow mask by means of a sputter, evaporator or E-beam irradiator. Next, the piezoelectric film 122 and the upper electrode 123 are dried at a predetermined temperature, for example, at about 100 to 110°C for about 5 to 10 minutes.

Next, the photoresist PR₁ is removed using acetone, thereby forming a space S having a predetermined width and height is formed between either side of the piezoelectric film 122 and the lower electrode 121, as shown in FIG. 5H.

Finally, the piezoelectric film 122 is sintered at a predetermined temperature, for example, about 900 to about 1,000°C, followed by applying an electric field to the piezoelectric film 122 to generate piezoelectric characteristics, which is called a polling process, thereby completing the piezoelectric actuator 120 according to the first embodiment of the present invention.

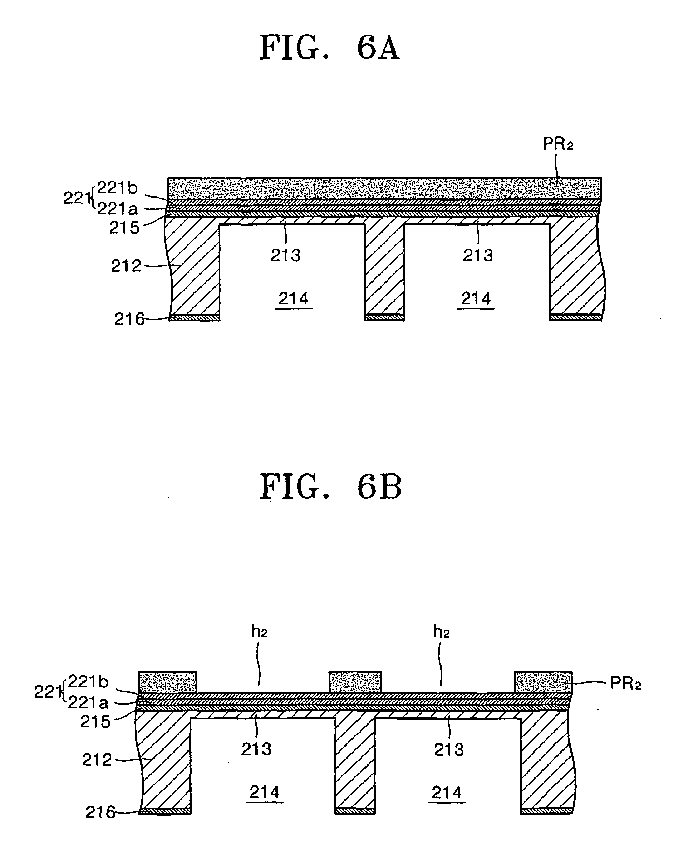

FIGS. 6A through 6E show sequential steps of a method of forming the piezoelectric actuator shown in FIG. 3.

Referring to FIG. 6A, oxide layers 215, 216 are formed on a top surface and on a bottom surface of a substrate 212. A pressure chamber 214 and a vibration plate 213 are formed on the substrate 212. A lower electrode 221, including a Ti layer 221 a and a Pt layer 221 b, is formed on the oxide layer 215. Steps followed by forming the lower electrodes 221 are the same as those shown of the method shown in FIGS. 5A through 5C, and description thereof will not be given.

Subsequently, a photoresist PR₂ is coated on the entire surface of the lower electrode 221 to a predetermined thickness, e.g., about 20 to about 40 µm. Here, a thickness of the photoresist PR₂ coated is greater than that of the photoresist PR₁ shown in FIG. 5D. Then, the coated photoresist PR₂ is exposed and developed for patterning, thereby forming an opening h₂ having a width of about 70 to 90% that of the pressure chamber 214 at a position corresponding to the pressure chamber 214, as shown in FIG. 6B. A portion of the lower electrode 121 is exposed through the opening h₂, exposing a portion of the lower electrode 221.

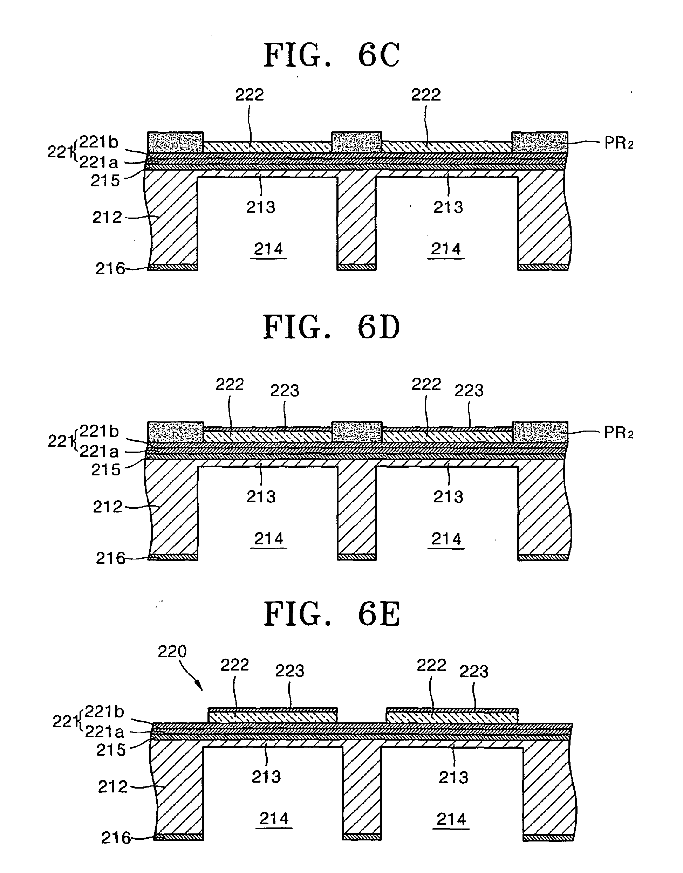

As shown in FIG. 6C, a piezoelectric material in a paste state is coated on the exposed lower electrode 221 by screen-printing. Here, the piezoelectric material should not deviate from the opening h₂. Accordingly, the piezoelectric film 222 is formed only within the opening h₂. Accordingly, PZT ceramic materials can be used as the piezoelectric material, which is the same as stated above.

Next, as shown in FIG. 6D, an upper electrode 223 is formed on the piezoelectric film 222. The method for forming the upper electrode 223 is the same as described in FIG. 5G, except that the upper electrode 223 of this embodiment is formed within the opening h₂, like the piezoelectric film 222. To this end, as described above, the photoresist PR₂ is preferably formed to have a relatively large height. Subsequently, the piezoelectric film 222 and the upper electrode 223 are dried at a temperature of about 100 to 110°C for about 5 to 10minutes.

Then, the photoresist PR₂ is removed using acetone, and the piezoelectric film 222, which is substantially perpendicular to the top surface of the lower electrode 221, and the upper electrode 223 having the same width as the piezoelectric film 222, are left on the lower electrode 221, as shown in FIG. 6E.

Finally, the piezoelectric film 222 is sintered at a predetermined temperature, for example, about 900 to about 1,000°C, followed by applying an electric field to the piezoelectric film 222 to generate piezoelectric characteristics, which is called a polling process, thereby completing the piezoelectric actuator 220 according to the second embodiment of the present invention.

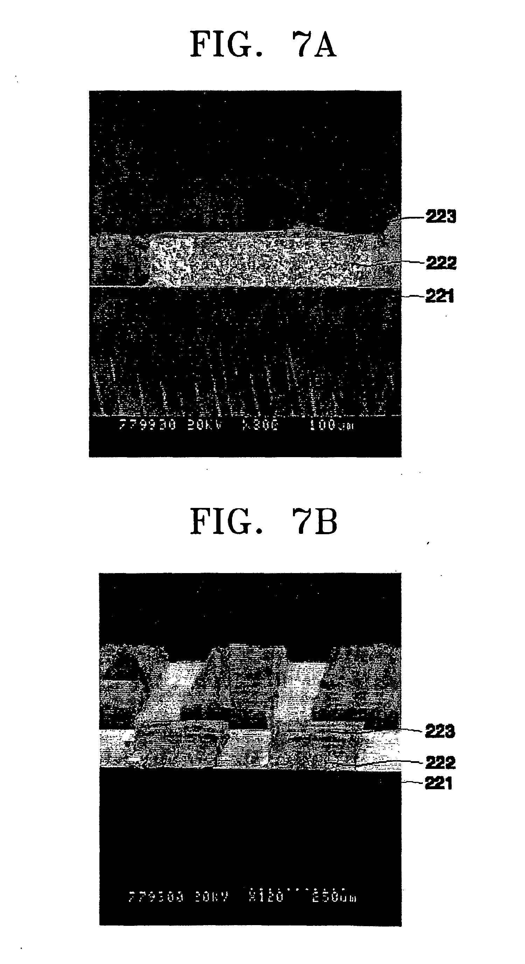

FIGS. 7A and 7B are scanning electron microscope pictures of the piezoelectric actuator formed by the method shown in FIGS. 6A through 6E.

Referring to FIGS. 7A and 7B, the lateral surface of the piezoelectric film 222 is at substantially right angle with respect to the top surface of the lower electrode 221. Also, the piezoelectric film 222 has a rectangular cross section having a substantially constant height, forming a hexahedral shape as a whole.

As described above, the piezoelectric actuator for an ink-jet printheadaccording to the present invention and a forming method thereof have the following effects.

A space is formed between a lower electrode and a peripheral portion of a piezoelectric film, and even if a relatively wide upper electrode is formed, short between the upper electrode and the lower electrode does not occur. Also, no breakdown occurs to the piezoelectric film during polling or driving. Therefore, sufficiently high piezoelectric effects can be exerted.

With reference to the actuator shown in Figure 3, if a lateral surface of the piezoelectric film is substantially perpendicular to the top surface of the lower electrode, the piezoelectric film has a rectangular cross section. Thus, a width of the upper electrode can be made the same as that of the piezoelectric film, thereby allowing the maximum piezoelectric effect to be exerted for the same area. Also, since a thickness of the piezoelectric film disposed below the upper electrode is constant, no short nor breakdown of the piezoelectric film occurs. Further, since the piezoelectric film is formed relatively thinly, e.g., to a predetermined thickness, a minute piezoelectric actuator can be formed accurately and easily. Therefore, the present invention can be suitably applied to a recent trend toward high-density printheads for high resolution printing.

While the present invention has been particularly shown and described with reference to preferred embodiments thereof, it will be understood by those of ordinary skill in the art that various changes in form and details may be made therein without departing from the scope of the invention as defined by the appended claims. For example, the methods for forming elements suggested above are provided just by way of examples, and various deposition methods and etching methods may be employed within the scope of the present invention. Also, the sequence of the respective steps may be different from the above illustration. Accordingly, it is intended that the scope of the invention be defined by the appended claims.

## Claims

1. A method for forming a piezoelectric actuator (120) for an ink-jet printhead, the piezoelectric actuator (120) being formed on a vibration plate (113) which forms an upper wall of a pressure chamber (114) and being for deforming the vibration plate (113) for providing a driving force to the pressure chamber (114) for ejecting ink, the method comprising:
forming a lower electrode (121) on the vibration plate (113);
forming a piezoelectric film (122) on the lower electrode (121) in a position that corresponds to the pressure chamber (114); and
forming an upper electrode (123) on the piezoelectric film (122);
wherein the method is **characterized in that** forming the piezoelectric film (122) and the upper electrode (123) comprises coating a photoresist (PR₁) on the entire surface of the lower electrode (121) to a predetermined thickness, patterning the photoresist (PR₁) to form an opening (h₁) in a position corresponding to the pressure chamber (114), coating a piezoelectric material on the lower electrode (121) exposed by the opening to form the piezoelectric film (122), forming the upper electrode (123) on the piezoelectric film (122), removing the photoresist (PR₁), sintering the piezoelectric film (122), and applying an electric field to the piezoelectric film (122) to provide piezoelectric properties,
wherein the piezoelectric material (122) is coated more widely than a width of the opening (h₁), so that a space (S) between the peripheral portion of the piezoelectric film (122) and the lower electrode (121) is formed when the photoresist (PR₁) is removed.

2. The method of claim 1, wherein a thickness of the photoresist coating (PR₁) is 2 to 8 µm.

3. The method of claim 1 or 2, wherein a width of the opening (h₁) is 70 to 90% that of the pressure chamber (114).

4. The method of any of claims 1 to 3, wherein the coating of the piezoelectric material is performed by screen printing.

5. The method of anyone of claims 1 to 4, wherein the pressure chamber (114) and the vibration plate (113) are formed in a silicon substrate (112) and a silicon oxide layer (115) is formed between the silicon substrate (112) and the lower electrode (121).

6. The method of any one of claims 1 to 5, wherein the lower electrode (121) is formed by sequentially depositing a Ti layer (121a) and a Pt layer (121 b) on the vibration plate (113) by sputtering.

7. The method of any one of claims 1 to 6, wherein the upper electrode (123) is formed by printing an electrode material on the piezoelectric film (122).

8. The method of any one of claims 1 to 7, wherein the upper electrode (123) is formed by depositing an electrode material on the piezoelectric film (122) by means of a sputterer, an evaporator or an E-beam irradiator.

## Patentansprüche

1. Verfahren zum Herstellen eines piezoelektrischen Aktuators (120) für einen Tintenstrahldruckkopf, wobei der piezoelektrische Aktuator (120) auf einer Vibrationsplatte (113) hergestellt wird, die eine obere Wand einer Druckkammer (114) bildet und zum Verformen der Vibrationsplatte (113) dient, um die Druckkammer (414) mit einer Antriebskraft zum Ausstoßen von Tinte zu beaufschlagen, wobei das Verfahren die folgenden Schritte beinhaltet:
Bilden einer unteren Elektrode (121) auf der Vibrationsplatte (113);
Bilden einer piezoelektrischen Folie (122) auf der unteren Elektrode (121) in einer Position, die der Druckkammer (114) entspricht; und
Bilden einer oberen Elektrode (123) auf der piezoelektrischen Folie (122);
wobei das Verfahren **dadurch gekennzeichnet ist, dass** das Bilden der piezoelektrischen Folie (122) und der oberen Elektrode (123) Folgendes beinhaltet: Auftragen eines Photoresists (PR₁) auf die gesamte Oberfläche der unteren Elektrode (121) bis auf eine vorbestimmte Dicke, Strukturieren des Photoresists (PR₁) zum Ausbilden einer Öffnung (h₁) an einer Stelle, die der Druckkammer (114) entspricht, Auftragen eines piezoelektrischen Materials auf die durch die Öffnung exponierte untere Elektrode (121) zum Bilden der piezoelektrischen Folie (122), Bilden der oberen Elektrode (123) auf der piezoelektrischen Folie (122), Entfernen des Photoresists (PR₁), Sintern der piezoelektrischen Folie (122) und Anlegen eines elektrischen Feldes an die piezoelektrische Folie (122), um piezoelektrische Eigenschaften zu erhalten,
wobei das piezoelektrische Material (122) breiter aufgetragen wird als die Breite der Öffnung (h₁), so dass ein Raum (S) zwischen dem peripheren Abschnitt der piezoelektrischen Folie (122) und der unteren Elektrode (121) entsteht, wenn der Photoresist (PR₁) entfernt wird.

2. Verfahren nach Anspruch 1, wobei eine Dicke der Photoresistschicht (PR₁) 2 bis 8 µm beträgt.

3. Verfahren nach Anspruch 1 oder 2, wobei eine Breite der Öffnung (h₁) 70 bis 90% von der der Druckkammer (114) beträgt.

4. Verfahren nach einem der Ansprüche 1 bis 3, wobei das Auftragen des piezoelektrischen Materials durch Siebdruck erfolgt.

5. Verfahren nach einem der Ansprüche 1 bis 4, wobei die Druckkammer (114) und die Vibrationsplatte (113) in einem Siliciumsubstrat (112) ausgebildet sind und eine Siliciumoxidschicht (115) zwischen dem Siliciumsubstrat (112) und der unteren Elektrode (121) gebildet wird.

6. Verfahren nach einem der Ansprüche 1 bis 5, wobei die untere Elektrode (121) durch sequenzielles Auftragen einer Ti-Schicht (121a) und einer Pt-Schicht (121b) auf die Vibrationsplatte (113) durch Aufstäuben gebildet wird.

7. Verfahren nach einem der Ansprüche 1 bis 6, wobei die obere Elektrode (123) durch Drucken eines Elektrodenmaterials auf die piezoelektrische Folie (1229 gebildet wird.

8. Verfahren nach einem der Ansprüche 1 bis 7, wobei die obere Elektrode (123) durch Auftragen eines Elektrodenmaterials auf die piezoelektrische Folie (122) mittels eines Aufstäubers, eines Evaporators oder eines Elektronenstrahlers gebildet wird.

## Revendications

1. Procédé de formation d'un actionneur piézoélectrique (120) pour une tête d'impression à jet d'encre, l'actionneur piézoélectrique (120) étant formé sur une plaque vibrante (113) qui forme une paroi supérieure d'une chambre de pression (114) et étant conçu pour déformer la plaque vibrante (113) afin de fournir une force d'entraînement à la chambre de pression (114) pour éjecter l'encre, le procédé comprenant :
la formation d'une électrode inférieure (121) sur la plaque vibrante (113) ;
la formation d'un film piézoélectrique (122) sur l'électrode inférieure (121) dans une position qui correspond à la chambre de pression (114) ; et
la formation d'une électrode supérieure (123) sur le film piézoélectrique (122) ;
le procédé étant **caractérisé en ce que** la formation du film piézoélectrique (122) et de l'électrode supérieure (123) comprend l'application d'une photorésine (PR₁) sur toute la surface de l'électrode inférieure (121) à une épaisseur prédéterminée, la formation d'un motif sur la photorésine (PR₁) pour former une ouverture (h₁) dans une position correspondant à la chambre de pression (114), le revêtement avec un matériau piézoélectrique de l'électrode inférieure (121) exposée par l'ouverture pour former le film piézoélectrique (122), la formation de l'électrode supérieure (123) sur le film piézoélectrique (122), l'enlèvement de la photorésine (PR₁), le frittage du film piézoélectrique (122), et l'application d'un champ électrique au film piézoélectrique (122) pour fournir les propriétés piézoélectriques,
dans lequel le revêtement de matériau piézoélectrique (122) est appliqué sur une largeur supérieure à celle de l'ouverture (h₁), de telle sorte qu'un espace (S) entre la partie périphérique du film piézoélectrique (122) et l'électrode inférieure (121) est formé lorsque la photorésine (PR₁) est enlevée.

2. Procédé selon la revendication 1, dans lequel une épaisseur du revêtement de photorésine (PR₁) est de 2 à 8 µm.

3. Procédé selon la revendication 1 ou 2, dans lequel une largeur de l'ouverture (h₁) est de 70 à 90% de celle de la chambre de pression (114).

4. Procédé selon l'une quelconque des revendications 1 à 3, dans lequel le revêtement de matériau piézoélectrique est appliqué par sérigraphie.

5. Procédé selon l'une quelconque des revendications 1 à 4, dans lequel la chambre de pression (114) et la plaque vibrante (113) sont formées dans un substrat de silicium (112) et une couche d'oxyde de silicium (115) est formée entre le substrat de silicium (112) et l'électrode inférieure (121).

6. Procédé selon l'une quelconque des revendications 1 à 5, dans lequel l'électrode inférieure (121) est formée par dépôt séquentiel d'une couche de Ti (121a) et d'une couche de Pt (121b) sur la plaque vibrante (113) par pulvérisation cathodique.

7. Procédé selon l'une quelconque des revendications 1 à 6, dans lequel l'électrode supérieure (123) est formée par impression d'un matériau d'électrode sur le film piézoélectrique (122).

8. Procédé selon l'une quelconque des revendications 1 à 7, dans lequel l'électrode supérieure (123) est formée par dépôt d'un matériau d'électrode sur le film piézoélectrique (122) au moyen d'un pulvérisateur, d'un évaporateur ou d'un irradiateur à faisceau électronique.
